# EUROPÄISCHE PATENTSCHRIFT

(11) **EP 1 763 594 B1**
(45) Veröffentlichungstag und Bekanntmachung des Hinweises auf die Patenterteilung: **19.12.2007**
(21) Anmeldenummer: 05774432.8
(22) Anmeldetag: 13.07.2005
(51) Int. Cl.: C23C 18/42, C23C 18/44, H05K 3/24

(54) **VERFAHREN ZUR VERBESSERUNG DER LÖTBARKEIT VON NICKELÜBERZÜGEN**
METHOD FOR IMPROVING SOLDERABILITY OF NICKEL COATINGS
PROCEDE POUR AMELIORER LA SOUDABILITE DE REVETEMENTS EN NICKEL

(30) Priorität: 14.07.2004 DE 102004033979
(43) Veröffentlichungstag der Anmeldung: 21.03.2007
(73) Patentinhaber: Dr.Ing. Max Schlötter GmbH & Co. KG, 73312 Geislingen/Steige (DE)
(72) Erfinder: ROUBAL, Jiri, 73337 Bad Überkingen (DE)
(74) Vertreter: HOFFMANN EITLE
(86) Internationale Anmeldenummer: PCT/EP2005/007618
(87) Internationale Veröffentlichungsnummer: WO 2006/005605

(56) Entgegenhaltungen:
- DE-A1- 19 631 565
- US-A- 4 424 241
- US-A- 5 882 736

## Beschreibung

Verfahren zur Abscheidung von Nickelüberzügen sind in der technischen Praxis weit verbreitet. Auf Oberflächen von Teilen aus z.B. Stahl, Kupfer, Kupferlegierungen, Zinkdruckguss und Aluminium werden Nickelüberzüge abgeschieden, um Korrosionsschutz, Anlaufbeständigkeit, Abriebfestigkeit zu erreichen. Die Überzüge werden elektrolytisch oder chemisch (außenstromlos) abgeschieden. Bei der außenstromlosen Metallabscheidung ist keine elektrische Kontaktierung notwendig. Dadurch ist es z.B. möglich, Metallmuster, d.h. elektrisch isolierte Oberflächenbereiche aus Metall, die auf einem Nichtleiter aufgebracht wurden, zu vernickeln. Zu Gegenständen dieser Art zählen u.a. Leiterplatten, wobei das Grundmaterial aus Kunststoff oder Keramik, die Metallmuster dann aus Kupfer bestehen.

Für das elektrolytische Abscheiden von matten oder glänzenden Nickelüberzügen stehen bekannte, kommerziell erhältliche Verfahren zur Verfügung. Matt-Nickel-Überzüge werden z.B. aus dem Watt's-Nickelbad abgeschieden. Dieses Bad enthält Nickelsulfat, Nickelchlorid, Borsäure und Netzmittel. Bäder auf Basis von anderen Nickelsalzen, wie z.B. Nickelsulfamat oder Nickelmethansulfonat, sind ebenfalls bekannt. Die Bäder zum Abscheiden von glänzenden Nickelüberzügen enthalten Nickelsalze, Puffersubstanzen, z.B. Borsäure, und organische Zusätze, die glanzbildend und einebnend wirken. Bei der Abscheidung von Nickelüberzügen werden üblicherweise folgende Bedingungen gewählt: Temperaturen im Bereich 40-70°C und eine kathodische Stromdichte im Bereich von 1 - 6 A/dm². Die Bedingungen hängen unter anderem von dem Badtyp und der Art der Nickelabscheidung ab. Verfahren zur Abscheidung von Nickelüberzügen sind z.B. in folgenden Publikationen beschrieben:
Robert Brugger, "Die galvanische Vemicklung", Eugen G. Leuze Verlag, 1984 J. W. Dettner, "Handbuch der Galvanotechnik", Carl Hanser Verlag, 1966.

Die Bäder für die chemische Nickelabscheidung enthalten Nickelsalze (z.B. Nickelsulfat, Nickelmethansulfonat, Nickelacetat, Nickelhypophosphit), Reduktionsmittel (z.B. Natriumhypophosphit, Dimethylaminoboran), Komplexbildner, Stabilisatoren und andere Zusätze wie Beschleuniger und Netzmittel. Eine ausführliche Beschreibung der Verfahren, Angaben zur Badzusammensetzung und zu Betriebsbedingungen findet man z.B. in der Publikation Wolfgang Riedel, "Funktionelle chemische Vernickelung", Eugen G. Leuze Verlag, 1989.

Bei dem elektrolytischen Verfahren werden praktisch Überzüge aus reinem Nickel abgeschieden. Die chemisch abgeschiedenen Nickelüberzüge enthalten, abhängig vom verwendeten Reduktionsmittel, weitere Bestandteile, wie z.B. Phosphor (je nach Art des Verfahrens bis ca. 15 Gew.-%) oder Bor (je nach Art des Verfahrens bis ca. 5 Gew.-%).

Weichlöten wird als Fügeverfahren bei der Herstellung von elektrischen und elektronischen Bauteilen häufig angewendet. Um eine einwandfreie Verbindung der Teile beim Löten zu erreichen, müssen die Oberflächen von den einzelnen Teilen während des Lötvorgangs mit dem Lot einwandfrei benetzen. Zum Löten wurden bisher zum größten Teil bleihaltige Lote wie z.B. Zinn-Blei-Weichlot verwendet. Allerdings geht in letzter Zeit die Tendenz dahin, bleifreie Lote, wie z.B. Zinn-Silber Weichlot einzusetzen.

Die Lötbarkeit wird z.B. nach DIN 32506 durch Hubtauchprüfung bewertet.

Die Benetzbarkeit von Nickeloberflächen mit Lot ist relativ schlecht, dies auch dann, wenn aktivierte Flussmittel verwendet werden.

Die elektrolytisch abgeschiedenen Matt-Nickel-Überzüge sind unmittelbar nach der Abscheidung zwar gut lötbar, die Lötbarkeit verschlechtert sich jedoch deutlich durch die Lagerung an der Luft. Die Verschlechterung der Lötbarkeit wird durch höhere Temperaturen beschleunigt. So sind die direkt nach der Abscheidung gut lötbare Nickelüberzüge z.B. nach einer Lagerung bei 270°C, 10 min lang nicht mehr lötbar.

Die Lötbarkeit der chemisch abgeschiedenen Nickelüberzüge ist bereits unmittelbar nach der Abscheidung unbefriedigend.

Durch die Abscheidung von Zinn oder Zinnlegierungen auf den Nickeloberflächen lässt sich das Problem der schlechten Lötbarkeit eliminieren. Durch das Abdecken der Oberfläche mit diesem Überzug, wobei Schichtdicken im Bereich von 2-5 µm abgeschieden werden, gehen jedoch einige vorteilhafte Eigenschaften von Nickel (z.B. Härte, Abriebfestigkeit, Bondbarkeit) verloren. Überzüge aus Zinn oder Zinnlegierungen können auf Nickel nur elektrolytisch abgeschieden werden. Aus diesem Grund ist das Metallisieren von Metallmustern entweder sehr aufwendig oder gar nicht durchführbar.

Um chemisch vernickelte Metallmuster lötbar zu machen, werden Goldüberzüge durch Zementation oder aus stromlosen Bädern, die Reduktionsmittel enthalten, abgeschieden (Coombs, C.F.Jr., Printed Circuit Handbook, Verlag Mc Graw-Hill, 2001). Gold löst sich in zinnhaltigen Loten während des Lötvorgangs und kann ab einer bestimmten Konzentration stören. Diese negative Eigenschaft vom Gold und der hohe Goldpreis müssen bei dem Einsatz dieses Verfahrens berücksichtigt werden.

Die Verwendung von Palladiumüberzügen als Schutzschichten für Metalloberflächen, wie z.B. Kupfer und Nickel bzw. Nickelüberzüge, ist in der Literatur bereits beschrieben.

In US 3,285,754 wird die Verwendung eines speziellen Palladiumnitritkomplexes für die Abscheidung von Palladium durch Zementation auf Metalloberflächen wie Kupfer, Silber, Blech, Aluminiumbronze, Phosphorbronze, Berylliumkupfer und unlegiertem Metall beschrieben, um Metalloberflächen stromlos mit einer einwandfreien und glänzenden Palladiumschicht zu versehen, wodurch sie vor Korrosion geschützt werden. Laut US 3,285,754 wird durch das beschriebene Verfahren ein Palladiumüberzug mit einer Palladiummenge von 4 bis 100 mg/dm² (¼ bis 10 mgm pro square inch) abgeschieden.

In DE 4 316 679 wird ein Verfahren beschrieben, bei dem zuerst Palladiumschichten auf Kupfer oder Nickel durch Zementation, dann stromlos, autokatalytisch abgeschieden werden, wobei in der ersten Stufe saure Lösungen, die Oxidationsmittel enthalten, verwendet werden. Die erste Stufe gemäß DE 4 316 679 dient als Vorbehandlung (Aktivierung) der Oberfläche für die nachfolgende stromlose Palladiumabscheidung. Die aufgebrachte Palladiumschicht soll z.B. als Korrosionsschutz dienen.

Aus DE 4 415 211 geht hervor, dass die Vorbehandlung der Oberfläche durch Abscheidung von Palladium durch Zementation nicht erforderlich ist, wenn Nickelüberzüge mit Palladium beschichtet werden sollen. Nach dieser Patentschrift werden Palladiumüberzüge auf Nickelüberzügen direkt autokatalytisch abgeschieden, um die Nickelüberzüge lötbar zu machen und sie gegen Korrosion zu schützen.

Die stromlose, autokatalytische Abscheidung von Palladium auf Metalloberflächen als Oxidationsschutz und um eine gute Lötbarkeit zu erreichen wird z.B. auch in EP 0 697 805 beschrieben. Bei diesem Verfahren wird ein Bad verwendet, das neben einem Palladiumsalz ein Reduktionsmittel für das Palladiumsalz enthält, wobei in der vorhergenannten Patentschrift Hypophosphit als Reduktionsmittel verwendet wird. Dabei werden nach EP 0 697 805 Palladiumschichten mit einer Dicke von 0,025-2,5, vorzugsweise 0,1-1 µm abgeschieden.

Die autokatalytischen, stromlosen Verfahren sind bezüglich der Badführung und Instandhaltung relativ aufwendig. Da die Bäder im metastabilen Zustand gehalten werden, besteht die Gefahr der Selbstzersetzung des Bades. Von Zersetzung des Bades spricht man im Zusammenhang der stromlosen autokatalytischen Abscheidung, wenn die Reduktion des Metallsalzes zum Metall nicht nur gezielt, selektiv auf den Oberflächen, die zu beschichten sind, abläuft, sondern spontan innerhalb der ganzen Palladiumlösung und auf den Wandungen des Badbehälters.

Der Unterschied der autokatalytischen Abscheidung gegenüber der Abscheidung von Metall durch Zementation besteht darin, dass bei der Abscheidung durch Zementation das Oberflächenmetall als Reduktionsmittel für das Metallsalz dient, weshalb die Abscheidung durch Zementation beendet ist, sobald die zu beschichtende Metalloberfläche bedeckt ist. Bei dem autokatalytischen Verfahren wirkt das auf der zu beschichtenden Oberfläche abgeschiedene Metall lokal als Katalysator für die weitere Reduktion von Metallsalzen durch das in der Lösung enthaltene Reduktionsmittel. Somit wird die Schichtdicke der stromlos autokatalytisch abgeschiedenen Metallschicht unter anderem dadurch bestimmt, wie lange der zu beschichtende Gegenstand in dem Behandlungsbad belassen wird.

Verfahren zur elektrolytischen Abscheidung von Palladium auf Nickelüberzügen bei der Herstellung von Leadframes sind z.B. in den Patentschriften US 6,139,977, US 6,159,623, US 4,911,798, US 4,911,799 beschrieben. Wie oben schon erwähnt besteht der Nachteil der elektrolytischen Abscheidung darin, dass sich voneinander isolierte Oberflächenbereiche nicht problemlos behandeln lassen.

Die Aufgabe, die dieser Erfindung zu Grunde liegt, besteht darin, ein einfaches Verfahren zur Verbesserung der Lötbarkeit von Nickelüberzügen zur Verfügung zu stellen, das nicht die Nachteile der bekannten Verfahren aufweist. Diese Aufgabe wird durch das erfindungsgemäße Verfahren gelöst, nach dem eine verbesserte Lötbarkeit eines Nickelüberzugs dadurch erreicht wird, dass eine Palladiumschicht durch Zementation aus einer sauren Palladiumsalzlösung abgeschieden wird.

Durch das erfindungsgemäße Verfahren werden folgende Vorteile erzielt:
- Das Verfahren ist im Vergleich zu Verfahren zur stromlosen, autokatalytischen Abscheidung einfach bei der Badführung. Die Gefahr der Selbstzersetzung des Bades ist ausgeschlossen.
- Bei dem erfindungsgemäßen Verfahren ist im Gegensatz zur elektrolytischen Abscheidung eine elektrische Kontaktierung der zu behandelnden Oberflächen nicht notwendig. Voneinander isolierte Oberflächenbereiche lassen sich dadurch problemlos behandeln.
- Im Gegensatz zu Schichten, die galvanisch abgeschieden werden, weist die durch Zementation gebildete Palladiumschicht eine gleichmäßige Schichtdickenverteilung auf.
- Bei der Abscheidung von Palladium durch Zementation auf Nickelüberzügen werden sehr dünne Palladiumschichten ausgebildet. Deshalb ist die Menge des auf der Oberfläche abgeschiedenen Metalls sehr gering. Dadurch bietet das Verfahren wirtschaftliche Vorteile.

Der mit Palladium zu beschichtende Nickelüberzug kann ein Überzug aus reinem Nickel sein oder aus einer Nickellegierung, wie sie - wie bereits oben angeführt - z.B. bei der chemischen Abscheidung von Nickel erhalten wird. Die Nickelüberzüge für die Anwendung des erfindungsgemäßen Verfahrens enthalten mindestens 80 Gew.% Nickel. Gemäß einer bevorzugten Ausführungsform der vorliegenden Erfindung sind die Nickelüberzüge für die Abscheidung des Palladiums durch Zementation elektrolytisch abgeschiedenen Mattnickelüberzüge, chemisch abgeschiedenen Nickel-Phosphor-Überzüge oder chemisch abgeschiedenen Nickel-Bor-Überzüge.

Im allgemeinen werden die vernickelten Gegenstände vor und nach der Behandlung in der sauren Palladiumsalzlösung mit Wasser gespült und im Anschluss an die Beschichtung mit Palladium getrocknet. Im Hinblick auf die optische Erscheinung des Nickelüberzugs wird die Zusammensetzung der Palladiumsalzlösung (z.B. die Art und Konzentration der Säure) sowie die Behandlungsbedingungen (z.B. die Temperatur und die Behandlungsdauer), üblicherweise so gewählt, dass der Nickelüberzug durch die Behandlung nicht sichtbar angegriffen wird, d.h. dass der Nickelüberzug nach der Behandlung keine mit bloßem Auge sichtbaren Defekte aufweist.

Die saure Palladiumsalzlösung kann beliebige Palladiumsalze enthalten, die bei dem gewählten pH Wert der resultierenden Palladiumsalzlösung löslich sind. Besonders geeignet sind z.B. Palladiumsulfat, Palladiumnitrat, Palladiumchlorid und/oder Palladiumacetat. Diese Salze sind kommerziell erhältlich.

Die Konzentration des Palladiums bezogen auf die Palladiumsalzlösung wird vorzugsweise auf 20 - 500 mg/l, besonders bevorzugt auf 50 - 200 mg/l eingestellt (die Konzentration des jeweils eingesetzten Palladiumsalzes wird entsprechend der gewünschten Palladiumkonzentration gewählt).

Die Art und die Konzentration der Säure wird für die für die Herstellung der sauren Palladiumsalzlösung so ausgewählt, dass die Palladiumsalzlösung weder den Nickelüberzug angreift, noch eine Reduktion des Palladiumsalzes bewirkt. Entsprechend werden die Behandlungsdauer und die Temperatur so eingestellt, dass die Nickelüberzüge nicht sichtbar angegriffen werden. Es können z.B. Schwefelsäure, Salzsäure, Phosphorsäure, Borfluorwasserstoffsäure, Essigsäure, Oxalsäure, Citronensäure, Milchsäure, Bernsteinsäure, Äpfelsäure, Methansulfonsäure und/oder Phenolsulfonsäure verwendet werden. Besonders geeignet für das erfindungsgemäße Verfahren sind Schwefelsäure, Phosphorsäure, Borfluorwasserstoffsäure, Essigsäure und/oder Oxalsäure.

Die Konzentration der Säuren wird bevorzugt im Bereich von 5-100 g/l eingestellt. Der pH-Wert der resultierenden Palladiumsalzlösung liegt bevorzugt im Bereich von 0 bis 4. Nach einer besonders bevorzugten Ausführungsform der vorliegenden Erfindung wird der pH Wert der Palladiumsalzlösung auf kleiner 1 eingestellt, da bei so niedrigen pH Werten die Palladiumsalze besonders stabil sind.

Die Neigung der Palladiumsalze zur Hydrolyse nimmt mit steigendem pH-Wert zu. Wird bei dem erfindungsgemäßen Verfahren der pH Wert auf einen Wert im Bereich von 1 bis 4 eingestellt, kann es vorteilhaft sein, Komplexbildner für Palladiumionen zuzugeben, um über eine längere Zeit eine Hydrolyse der Palladiumsalze zu unlöslichen Verbindungen zu verhindern.

Komplexbildner für Palladiumionen sind allgemein bekannt. Beispielsweise können Ammoniak und/oder Aminoverbindungen verwendet werden. Bevorzugte Bespiele für solche Verbindungen sind Methylamin, Ethylendiamin, Dimethylamin, Monoethanolamin, Anilin, Toluidin, Benzylamin, 1,3-Diaminopropan, Diethylaminopropylamin und Tetrakis-(2-Isopropyl)-ethylendiamin.

Substanzen, die mit Palladium anionische Komplexe bilden, können ebenfalls als Komplexbildner in dem erfindungsgemäßen Verfahren eingesetzt werden. Zum Beispiel bilden Chloride oder Bromide mit den Palladiumionen [PdCl₄]²⁻- oder [PdBr₄]²⁻-Komplexe. Diese Verbindungen bleiben bei höherem pH-Wert stabil und sind daher für die Herstellung der Behandlungslösung ebenfalls geeignet.

Die Abscheidung von Palladium durch Zementation erfolgt vorzugsweise bei Temperaturen von 10-80°C, besonders bevorzugt bei Raumtemperatur bis 60°C. Expositionszeiten der Nickelüberzüge mit der sauren Palladiumsalzlösung im Bereich von 0,5-10 Minuten sind ausreichend.

Das erfindungsgemäße Verfahren eignet sich sowohl zur Verbesserung der Lötbarkeit von Nickelüberzügen beim Einsatz bleihaltiger Lote als auch beim Einsatz bleifreier Lote.

Bei dem erfindungsgemäßen Verfahren wird Palladium durch Zementation abgeschieden. Die Menge des so abgeschiedenen Palladiums ist sehr gering, so dass der gebildete Palladiumüberzug optisch kaum oder überhaupt nicht wahrnehmbar ist. Durch Analysen nach der Auflösung der abgeschiedenen Palladiumschicht wurde ermittelt, dass die abgeschiedene Palladiummenge nur ca. 1 - 2 mg/dm² beträgt. Dies entspricht einer Schichtdicke von 0,008 - 0,016 µm.

Es ist überraschend, dass das erfindungsgemäße Verfahren die Lötbarkeit der Nickelüberzüge verbessert, obwohl die durch Zementation gebildete Palladiumschicht extrem dünn ist.

### Beispiele, Referenzbeispiele und Vergleichsbeispiele

Kupferbleche wurden nach verschiedenen Verfahren, wie weiter unten beschrieben, mit unterschiedlichen Nickelüberzügen beschichtet (Referenzbeispiele). Diese Nickelüberzüge wurden entweder auf ihre Lötbarkeit getestet (Vergleichsbeispiele) oder es wurde erfindungsgemäß durch Behandlung mit einer sauren Palladiumsälzlösung durch Zementation eine Palladiumschicht darauf abgeschieden (Beispiele).

Die Lötbarkeit der Oberflächen wurde nach der Hubtauchprüfung gemäß DIN 32506 geprüft. Die Prüfung der Lötbarkeit erfolgte entweder unmittelbar nach der Herstellung der Proben oder nach ihrer Temperung für 10 min bei 270 °C. Durch die Temperung wurde die Alterung bzw. Verhältnisse, die beim Reflowlöten zustande kommen, simuliert. Als Flussmittel für die Prüfung der Lötbarkeit wurde ein halgenfreies Flussmittel auf Alkoholbasis verwendet (Produkt "ELI 0099", Hersteller: Felder GmbH Löttechnik in D-46047 Oberhausen, die Art gemäß DIN EN 29454, Teil 1: 2.1.3.A). Die Eintauchgeschwindigkeit bei der Durchführung der Lötbarkeitsprüfung nach DIN 32506 wurde bei allen Prüfungen auf 10 mm/s und die Verweildauer im Lötbad auf 10 Sekunden eingestellt. Als Lot wurde Weichlot DIN 1707-L-Sn60Pb verwendet, die Lötbadtemperatur wurde auf 230°C eingestellt. Alternativ wurde die Lötbarkeitsprüfung auch mit bleifreiem Zinn-Silber-Lot geprüft (Beispiel 5 und Vergleichsbeispiel 5). Die Zusammensetzung des Zinn-Silber-Lots ist 3,5 Gew.% Silber und 96,5 Gew.% Zinn.

Die Bewertung der Lötbarkeit erfolgte durch optische Beurteilung der Oberfläche. Das Ergebnis der Lötbarkeitsprüfung wurde als sehr gut bezeichnet, wenn die Glätte der Oberfläche nach der Prüfung dem Bild 1 aus DIN 32506 Teil 2 bzw. Teil 3 entsprach.

### Referenzbeispiele 1-5, Beispiele 1-5 und Vergleichsbeispiele 1-5

Die Nickelüberzüge wurden durch Vernickelung von Kupferblechen in den unten aufgeführten Nickelbädern hergestellt (Referenzbeispiele).

### Referenzbeispiel 1:

| Nickelbad: | |
|---|---|
| Nickel (als Nickelsulfat) | 7 g/l |
| Milchsäure (92 %) | 30 g/l |
| Essigsäure | 15 g/l |
| Propionsäure | 2 g/l |
| Glycin | 5 g/l |
| Natriumhydroxid | 15 g/l |
| Blei als Bleiacetat | 1 mg/l |
| Cadmium als Cadmiumsulfat | 1 mg/l |
| Natriumhypophosphit | 25 g/l |

Das Kupferblech wurde in dem Nickelbad mit einem pH Wert von 4,5 bei 90°C für 20 min vernickelt.

### Referenzbeispiel 2:

| Nickelbad: | |
|---|---|
| Nickel (als Nickelsulfat) | 7 g/l |
| Milchsäure (92 %) | 30 g/l |
| Essigsäure | 15 g/l |
| Propionsäure | 2 g/l |
| Glycin | 5 g/l |
| Natriumhydroxid | 15 g/l |
| Blei als Bleiacetat | 1 mg/l |
| Thioharnstoff | 2 mg/l |
| Natriumhypophosphit | 25 g/l |

Ein Kupferblech wurde in dem Nickelbad mit einem pH Wert von 4,5 bei 90 °C für 20 min vernickelt.

### Referenzbeispiel 3:

| Nickelbad: | |
|---|---|
| Nickel (als Nickelsulfat) | 7 g/l |
| Milchsäure (92 %) | 45 g/l |
| Natriumacetat | 16 g/l |
| Natriumhydroxid | 15 g/l |
| Thioharnstoff | 2 mg/l |
| Natriumhypophosphit | 25 g/l |

Ein Kupferblech wurde in dem Nickelbad mit einem pH Wert von 4,5 bei 90°C für 20 min vernickelt.

### Referenzbeispiel 4:

Als Nickelbad wurde SLOTONIP 30-1, erhältlich bei der Fa. Dr.-Ing. Max Schlötter GmbH & Co. KG in D-73312 Geislingen/Steige eingesetzt. Das chemische Nickelbad SLOTONIP 30-1 enthält Nickelsulfat, Natriumhypophosphit als Reduktionsmittel, Hydroxycarbonsäuren als Komplexbildner und Bleiacetat als Stabilisator. In diesem Bad werden chemisch Nickel-Phosphor-Überzüge mit 8 - 10 Gew.% Phosphor abgeschieden. Der pH-Wert- wurde auf 4,5, die Temperatur auf 90°C eingestellt. Die Behandlungsdauer des Kupferblechs für die Vernickelung betrug 20 Minuten.

### Referenzbeispiel 5:

Als Nickelbad wurde SLOTONIP 30-3, erhältlich bei der Fa. Dr.-Ing. Max Schlötter GmbH & Co. KG in D-73312 Geislingen/Steige, eingesetzt. Das chemische Nickelbad SLOTONIP 30-3 enthält Nickelsulfat, Natriumhypophosphit als Reduktionsmittel, Hydroxycarbonsäuren als Komplexbildner und eine Schwefelverbindung als Stabilisator. In diesem Bad werden chemisch Nickel-Phosphor-Überzüge mit 7 - 8 Gew.% Phosphor abgeschieden. Der pH-Wert wurde auf 4,5, die Temperatur auf 90°C eingestellt. Die Behandlungsdauer für die Herstellung des Nickel-Phosphor-Überzugs betrug 20 Minuten.

### Beispiel 1-5:

Die wie in den Referenzbeispielen 1-5 hergestellten Nickelüberzüge wurden in Leitungswasser gespült. Dann wurden die vernickelten Kupferbleche in die unten angegebene saure Palladiumsalzlösung bei Raumtemperatur für 3 min eingetaucht (Beispiele 1-5).

### Die Palladiumsalzlösung hatte folgende Zusammensetzung:

| | |
|---|---|
| Palladium (als Palladiumnitrat) | 200 mg/l |
| Schwefelsäure (96 %) | 100 g/l |

Die Nickelüberzüge wurden von den Palladiumsalzlösungen nicht angegriffen, das Aussehen der Oberfläche des Nickelüberzugs nach der Abscheidung der Palladiumschicht durch Zementation war vergleichbar zu den unbehandelten, vernickelten Kupferblechen. Bei der Durchführung der Lötbarkeitsprüfung der mit Palladium beschichteten Nickelüberzüge aus den Beispielen 1-5 wurden diese vollständig und sehr gleichmäßig mit Lot benetzt, weshalb ihre Lötbarkeit mit sehr gut beurteilt wurde.

Der in der Palladiumsalzlösung behandelte Nickelüberzug aus Beispiel 5 wurde außerdem einer Lötbarkeitsprüfung im Zinn-Silber-Lot anstelle des ansonsten verwendeten Zinn-Blei-Lots DIN 1707-L-Sn60Pb unterzogen (Zusammensetzung des Lots: 3,5 Gew.% Silber, 96,5 Gew.% Zinn).

| | |
|---|---|
| Lötbadtemperatur: | 245°C |
| Verweildauer im Lötbad: | 10 s |
| Eintauchgeschwindigkeit: | 10 mm/s |

Das Blech, das in der Palladiumsalzlösung behandelt wurde, war nach der Prüfung der Lötbarkeit vollständig und sehr gleichmäßig mit Lot benetzt.

Ein gemäß Bespiel 5 mit einer Palladiumschicht überzogener Nickelüberzug wurde in Salpetersäure aufgelöst und die Menge an Palladium quantitativ analysiert. Die. Analyse ergab, dass die auf dem Nickel abgeschiedene Palladiummenge 1,88 mg/dm² beträgt.

### Vergleichsbeispiele 1-5:

Wurden die Nickelüberzüge, die in den Referenzbeispielen 1-5 hergestellt wurden, dagegen nicht in einer Palladiumsalzlösung behandelt (Vergleichsbeispiele 1-5), wurden sie bei der Durchführung der Lötbarkeitsprüfung nur unvollständig mit Lot bedeckt und die Oberfläche war nicht glatt.

Ein gemäß Referenzbeispiel 5 hergestellter Nickelüberzug, der ohne Behandlung in der Palladiumsalzlösung der Prüfung der Lötbarkeit unterzogen wurde (Vergleichsbeispiel 5), war auch bei der Lötbarkeitsprüfung im Zinn-Silber-Lot nur unvollständig mit Lot bedeckt.

### Referenzbeispiel 6

Kupferbleche wurden im Nickelbad NIBODUR GJN, erhältlich bei der Fa. Dr.-Ing. Max Schlötter GmbH & Co. KG in D-73312 Geislingen/Steige, chemisch vernickelt. Das chemische Nickelbad NIBODUR GJN enthält Nickelsulfat, Dimethylaminoboran als Reduktionsmittel, Hydroxycarbonsäuren als Komplexbildner und eine Schwefelverbindung als Stabilisator. Aus diesem Bad wurden Nickel-Bor-Überzüge mit 1-2 Gew.% Bor abgeschieden. Für die Vemickelung wurde der pH-Wert auf 6,0, die Temperatur auf 65°C eingestellt, die Behandlungsdauer betrug 30 Minuten.

### Beispiel 6

Das vernickelte Kupferblech aus Referenzbeispiel 6 wurde wie in den Beispielen 1 - 5 mit der gleichen Palladiumsalzlösung bei Raumtemperatur für 3 min behandelt. Die Lötbarkeit des mit Palladium beschichteten Nickelüberzugs aus Beispiel 6 wurde nach Temperung für 10 min bei 270°C beurteilt. Die Oberfläche war vollständig mit Lot bedeckt und glatt.

### Vergleichsbeispiel 6

Im Vergleichsbeispiel 6 wurde die Lötbarkeit des gemäß Referenzbeispiels 6 hergestellten Nickelüberzugs unmittelbar nach der Abscheidung des Nickelüberzugs und nach dem Tempern (270°C, 10 min) geprüft. Unmittelbar nach der Abscheidung war der Nickelüberzug fast vollständig mit Lot benetzt, jedoch nicht so glatt wie bei Beispiel 6. Die Temperung verschlechterte das Lötergebnis der nicht in der Palladiumsalzlösung behandelten Nickeloberfläche sehr wesentlich: Die Oberfläche war mit Lot unvollständig bedeckt und nicht mehr glatt.

### Referenzbeispiel 7

Kupferbleche wurden im Mattnickelbad elektrolytisch vernickelt. Dazu wurde das Nickelbad NORMA der Fa. Dr.-Ing. Max Schlötter GmbH & Co. KG in D-73312 Geislingen, das aus Nickelsulfat, Nickelchlorid, Borsäure und Netzmittel besteht, verwendet.

### Beispiel 7

Der Nickelüberzug aus Referenzbeispiel 7 wurde wie in den Beispielen 1 bis 6 mit der dort beschriebenen Palladiumsalzlösung behandelt. Die Lötbarkeitsprüfung des mit Palladium beschichteten Nickelüberzugs unmittelbar nach der Behandlung mit der Palladiumsalzlösung und nach dem Tempern (270 °C, 10 min) ergaben einwandfreie Ergebnisse.

### Vergleichsbeispiel 7

Im Vergleichsbeispiel 7 wurde die Lötbarkeit des gemäß Referenzbeispiel 7 hergestellten Nickelüberzugs unmittelbar nach der Abscheidung des Nickelüberzugs und Tempern (270 °C, 10 min) geprüft. Direkt nach der Abscheidung war die Lötbarkeit sehr gut, nach dem Tempern unbefriedigend. Die Oberfläche war nicht mehr glatt und unvollständig mit Lot benetzt.

### Beispiele 8 - 12

Nickelüberzüge, die gemäß Referenzbeispiel 4 hergestellt wurden (chemische Vernickelung im Nickelbad SLOTONIP 30-1), wurden 3 min bei Raumtemperatur mit den unten beschriebenen Palladiumsalzlösungen behandelt, bei denen die Palladiumkonzentration und die Art der Säure variiert wurden. Als Palladiumsalz wurde Palladiumnitrat verwendet. Die Angaben zur Zusammensetzung und die Ergebnisse nach dem Löttest sind in der Tabelle 1 dargestellt.

**Tabelle 1:**

| Beispiel-Nr. | Palladium-konzentration (mg/l) | Art der Säure | Konzentration der Säure (g/l) | Ergebnis der Lötbarkeitsprüfung |
|---|---|---|---|---|
| 8 | 200 | Schwefelsäure | 20 | sehr gut |
| 9 | 50 | Schwefelsäure | 20 | sehr gut |
| 10 | 200 | Phosphorsäure | 100 | sehr gut |
| 11 | 200 | Essigsäure | 50 | sehr gut |
| 12 | 200 | Oxalsäure | 100 | sehr gut |

### Beispiel 13:

Ein Nickelüberzug, der gemäß Referenzbeispiel 4 durch chemische Vernickelung eines Kupferblechs im Nickelbad SLOTONIP 30-1 hergestellt wurde, wurde für 3 min bei Raumtemperatur in einer Palladiumsalzlösung behandelt. Die Palladiumsalzlösung hatte folgende Zusammensetzung:

| | |
|---|---|
| Palladium (als Palladiumsulfat) | 200 mg/l |
| Schwefelsäure (96%) | 100 g/l |

Das Blech wurde nach der Lötbarkeitsprüfung vollständig und sehr gleichmäßig mit Lot benetzt.

### Beispiel 14:

Ein Nickelüberzug, der gemäß Referenzbeispiel 4 durch chemische Vernickelung eines Kupferblechs im Nickelbad SLOTONIP 30-1 hergestellt wurde, wurde für 3 min bei Raumtemperatur in einer Palladiumsalzlösung behandelt. Die Palladiumsalzlösung hatte folgende Zusammensetzung:

| | |
|---|---|
| Palladium (als Palladiumacetat) | 200 mg/l |
| Schwefelsäure (96%) | 100 g/l |

Das Blech wurde nach der Lötbarkeitsprüfung vollständig und sehr gleichmäßig mit Lot benetzt.

### Beispiele 15-18:

Ein Nickelüberzug, der gemäß Referenzbeispiel 4 durch chemische Vemickelung eines Kupferblechs im Nickelbad SLOTONIP 30-1 hergestellt wurde, wurde in einer Palladiumsalzlösung wie in Beispiel 1 bei Raumtemperatur behandelt. Dabei wurden verschiedene Behandlungszeiten gewählt. Die Ergebnisse der Prüfung der Lötbarkeit sind in der Tabelle 2 aufgeführt. Tabelle 2:

| Beispiel-Nr. | Behandlungsdauer (min) | Ergebnis der Lötbarkeitsprüfung |
|---|---|---|
| 15 | 0,5 | sehr gut |
| 16 | 1 | sehr gut |
| 17 | 2 | sehr gut |
| 18 | 10 | sehr gut |

### Beispiel 19 bis 22:

Ein Nickelüberzug, der gemäß Referenzbeispiel 4 durch chemische Vernickelung eines Kupferblechs im Nickelbad SLOTONIP 30-1 hergestellt wurde, wurde mit einer Palladiumsalzlösungen behandelt. Die Behandlung in der Palladiumsalzlösung erfolgte bei Raumtemperatur, 3 Minuten lang. Die Palladiumsalzkonzentration war 200 mg/l. Zur Herstellung der Lösungen wurde Palladiumnitrat verwendet. Die weiteren Bestandteile der Lösungen waren:

### Beispiel 19:

| | |
|---|---|
| Salzsäure (37%) | 20 ml/l |
| Natriumchlorid | 5 g/l |

Der pH-Wert wurde mit Natriumhydroxid auf 2,5 eingestellt.

### Bespiel 20:

| | |
|---|---|
| Schwefelsäure (96 %) | 20 g/l |

Der pH-Wert wurden mit konz. Ammoniaklösung auf 2,3 eingestellt.

### Beispiel 21:

| | |
|---|---|
| Schwefelsäure (96 %) | 5 g/l |

Der pH-Wert wurde mit Ethanolamin auf 2,3 eingestellt.

### Beispiel 22:

| | |
|---|---|
| Schwefelsäure (96 %) | 5 g/l |

Der pH-Wert wurde mit Ethylamin auf 2,3 eingestellt.

Die Lötbarkeitsprüfung für Beispiele 19-22 erfolgte direkt nach der Behandlung der Nickelüberzüge mit der Palladiumsalzlösung. Die Ergebnisse der Prüfung der Lötbarkeit waren bei allen Proben sehr gut.

### Beispiel 23:

Ein Kupferblech, wie im Beispiel 20 beschrieben vernickelt, wurde in einer Palladiumsalzlösung der gleichen Zusammensetzung, wie im Beispiel 20 für 3 min behandelt, die Temperatur wurde im Unterschied zum Beispiel 20 auf 50 °C eingestellt.

Die Lötbarkeit wurde direkt nach der Behandlung geprüft. Das Ergebnisse der Lötbarkeitsprüfung für Beispiele 19 bis 22 waren sehr gut.

### Beispiel 24:

Ein Nickelüberzug, hergestellt gemäß Referenzbeispiel 4, wurde mit der Palladiumsalzlösung aus Beispiel 20 behandelt. Der pH-Wert der Palladiumsalzlösung wurde auf 4,0 und die Behandlungstemperatur auf 80 °C eingestellt. Die Behandlungsdauer betrug 3 Minuten.

Das Ergebnis der Lötbarkeitsprüfung war sehr gut.

## Patentansprüche

1. Verfahren zur Verbesserung der Lötbarkeit von Nickelüberzügen, **dadurch gekennzeichnet, dass** auf den Nickelüberzügen eine Palladiumschicht aus einer sauren Palladiumsalzlösung ausschließlich durch Zementation abgeschieden wird.

2. Verfahren nach Anspruch 1, **dadurch gekennzeichnet, dass** Schwefelsäure, Phosphorsäure, Borfluorwasserstoffsäure, Essigsäure und/oder Oxalsäure für die Herstellung der sauren Palladiumsalzlösung verwendet werden.

3. Verfahren nach Anspruch 1 oder 2, **dadurch gekennzeichnet, dass** der pH-Wert der Palladiumsalzlösung auf 0 bis 4 eingestellt wird.

4. Verfahren nach Anspruch 3, **dadurch gekennzeichnet, dass** der pH-Wert der Palladiumsalzlösung auf < 1 eingestellt wird.

5. Verfahren nach Anspruch 3, **dadurch gekennzeichnet, dass** der pH-Wert der Palladiumsalzlösung in einem Bereich von 1 - 4 eingestellt wird.

6. Verfahren nach einem oder mehreren der Ansprüche 1 bis 5, **dadurch gekennzeichnet, dass** der Palladiumsalzlösung mindestens ein Komplexbildner für Palladiumionen zugesetzt wird.

7. Verfahren nach Anspruch 6, **dadurch gekennzeichnet, dass** als Komplexbildner Chloride und/oder Bromide verwendet werden.

8. Verfahren nach Anspruch 6, **dadurch gekennzeichnet, dass** Ammoniak und/oder Aminoverbindungen als Komplexbildner verwendet werden.

9. Verfahren nach Anspruch 8, **dadurch gekennzeichnet, dass** die Aminoverbindungen ausgewählt sind aus Methylamin, Ethylendiamin, Dimethylamin, Monoethanolamin, Anilin, Toluidin, Benzylamin, 1,3-Diaminopropan, Diethylaminopropylamin und Tetrakis-(2-Isopropyl)-ethylendiamin.

10. Verfahren nach einem oder mehreren der vorhergehenden Ansprüche, **dadurch gekennzeichnet, dass** die Nickelüberzüge für die Abscheidung des Palladiums durch Zementation ausgewählt sind aus elektrolytisch abgeschiedenen Mattnickelüberzügen, chemisch abgeschiedenen Nickel-Phosphor-Überzügen und chemisch abgeschiedenen Nickel-Bor-Überzügen.

## Claims

1. Process for improving the solderability of nickel coatings, **characterised in that** a palladium layer is deposited from an acid palladium salt solution onto the nickel coatings exclusively by cementation.

2. Process according to claim 1, **characterised in that** sulphuric acid, phosphoric acid, hydroborofluoric acid, acetic acid and/or oxalic acid are used for the production of the acid palladium salt solution.

3. Process according to claim 1 or 2, **characterised in that** the pH value of the palladium salt solution is adjusted to 0 to 4.

4. Process according to claim 3, **characterised in that** the pH value of the palladium salt solution is adjusted to < 1.

5. Process according to claim 3, **characterised in that** the pH value of the palladium salt solution is adjusted in a range from 1 - 4.

6. Process according to one or more of claims 1 to 5, **characterised in that** at least one complex former for palladium ions is added to the palladium salt solution.

7. Process according to claim 6, **characterised in that** chlorides and/or bromides are used as complex formers.

8. Process according to claim 6, **characterised in that** ammonia and/or amino compounds are used as complex formers.

9. Process according to claim 8, **characterised in that** the amino compounds are selected from methylamine, ethylene diamine, dimethylamine, monoethanolamine, aniline, toluidine, benzylamine, 1,3-diaminopropane, diethylaminopropylamine and tetrakis-(2-isopropyl)-ethylenediamine.

10. Process according to one or more of the preceding claims, **characterised in that** the nickel coatings for the deposition of palladium by cementation are selected from electrolytically deposited matt nickel coatings, chemically deposited nickel-phosphorus coatings and chemically deposited nickel-boron coatings.

## Revendications

1. Procédé pour l'amélioration de la soudabilité de revêtements en nickel, **caractérisé en ce qu'**une couche de palladium est déposée exclusivement par cémentation sur les revêtements en nickel à partir d'une solution acide de sel de palladium.

2. Procédé selon la revendication 1, **caractérisé en ce que** de l'acide sulfurique, de l'acide phosphorique, de l'acide borofluorhydrique, de l'acide acétique et/ou de l'acide oxalique sont utilisés pour la fabrication de la solution acide de sel de palladium.

3. Procédé selon la revendication 1 ou 2, **caractérisé en ce que** la valeur Ph de la solution de sel de palladium est réglée à une valeur allant de 0 à 4.

4. Procédé selon la revendication 3, **caractérisé en ce que** la valeur PH de la solution de sel de palladium est <1.

5. Procédé selon la revendication 3, **caractérisé en ce que** la valeur Ph de la solution de sel de palladium est amenée à un niveau allant de 1 à 4.

6. Procédé selon une ou plusieurs des revendications 1 à 5, **caractérisé en ce qu'**au moins un agent complexant d'ions de palladium est ajouté à la solution de sel de palladium.

7. Procédé selon la revendication 6, **caractérisé en ce qu'**on utilise comme agent complexant des chlorures et/ou des bromures.

8. Procédé selon la revendication 6, **caractérisé en ce qu'**on utilise comme agent complexant de l'ammoniaque et/ou des combinaisons aminées.

9. Procédé selon la revendication 8, **caractérisé en ce que** les combinaisons aminées sont sélectionnées à partir de méthylamine, éthylènediamine, diméthylamine, monoéthanolamine, aniline, toluidine, benzylamine, 1,3-diaminopropane, diéthylamineprolamine et tétrakis-(2-isopropyle)-éthylènediamine.

10. Procédé selon une ou plusieurs des revendications précédentes, **caractérisé en ce que** les revêtements en nickel pour le dépôt du palladium par cémentation sont sélectionnés parmi des revêtements en nickel mat déposés électrolytiquement, des revêtements nickelphosphore déposés chimiquement et des revêtements nickel-bore déposés chimiquement.
